# EUROPÄISCHE PATENTANMELDUNG

(11) **EP 3 546 968 A1**
(43) Veröffentlichungstag der Anmeldung: **02.10.2019**
(21) Anmeldenummer: 18164026.9
(22) Anmeldetag: 26.03.2018
(51) Int. Cl.: G01R 33/3415, G01R 33/36

(54) **KONFIGURIERBARE LOKALSPULENMATRIX UND VERFAHREN ZUM BETRIEB**

(71) Anmelder: Siemens Healthcare GmbH, 91052 Erlangen (DE)
(72) Erfinder: Horger, Wilhelm, 90571 Schwaig (DE); Carinci, Flavio, 91052 Erlangen (DE); Achleitner, Roman, 90419 Nürnberg (DE); Ferguson, George William, 91056 Erlangen (DE); Hesels, Katharina, 91058 Erlangen (DE); Norosinski, Sabine, 91080 Spardorf (DE); Vollmer, Jonas, 91054 Erlangen (DE)

(57) **Zusammenfassung**

Die Erfindung betrifft eine Lokalspulenmatrix und ein Verfahren zum Betrieb eines Magnetresonanztomographen mit der Lokalspulenmatrix. Die Lokalspulenmatrix weist eine Mehrzahl an Spulenwicklungen auf. Die Lokalspulenmatrix ist ausgelegt, bei einer Magnetresonanztomographie einen vorbestimmten Bereich eines in Nachbarschaft zu der Lokalspule angeordneten Patienten mit auswählbaren unterschiedlich großen Sensitivitätsbereichen erfassen zu können.

## Beschreibung

Die Erfindung betrifft eine Lokalspulenmatrix für eine Magnetresonanzmessung sowie ein Verfahren zum Betrieb der Lokalspulenmatrix. Die Lokalspulenmatrix weist eine Mehrzahl an Spulenwicklungen auf.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, auch als Magnetresonanzsignal bezeichnet, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Die erzeugte Darstellung gibt eine räumliche Dichteverteilung der Spins an.

Die empfangenen Magnetresonanzsignale sind sehr schwach, d.h. teilweise nur knapp über der Rauschgrenze. Um das Signal zu optimieren, werden sogenannte Lokalspulen möglichst nahe am Körper des Patienten positioniert. Kleinere Spulenwicklungen erlauben dabei ein besseres Signal-zu-Rausch-verhältnis für oberflächennahe Bereiche und wegen disjunkter Sensitivitätsbereiche auch eine parallele Abtastung mehrere Bereiche zur Beschleunigung der Bilderfassung. Größere Spulenwicklungen hingegen haben einen Sensitivitätsbereich, der weiter in den Körper hineinreicht, um z.B. innere Organe zu erfassen. Je nach Anwendung sind daher unterschiedliche und kostspielige Lokalspulen erforderlich, die auch noch beim Tausch zusätzliche Zeit erfordern.

Es ist daher eine Aufgabe der vorliegenden Erfindung, eine Lokalspule bereitzustellen, die kosteneffizienter ist.

Die Aufgabe wird durch die erfindungsgemäße Lokalspulenmatrix nach Anspruch 1 und ein Verfahren zum Betrieb nach Anspruch 11 gelöst.

Die erfindungsgemäße Lokalspulenmatrix weist eine Mehrzahl an Spulenwicklungen auf. Als Spulenwicklungen werden dabei Antennenspulen bezeichnet, die ausgelegt sind, magnetische Wechselfelder, insbesondere durch Kernspins erzeugt, zu erfassen und in elektrische Signale für eine Bilderfassung zu wandeln. Die Lokalspulenmatrix ist dabei ausgelegt, bei einer Magnetresonanztomographie einen vorbestimmten Bereich eines in Nachbarschaft zu der Lokalspule angeordneten Patienten mit auswählbaren unterschiedlich großen Sensitivitätsbereichen erfassen zu können. Als Sensitivitätsbereich wird dabei der Bereich im Raum bezeichnet, indem die Spulenwicklung nur eine geringe Abnahme der durch ein magnetisches Wechselfeld induzierten Spannung bzw. Strom gegenüber einer Magnetfeldquelle im Mittelpunkt einer von der Spulenwicklung umschlossenen Fläche aufweist. Dabei kann es auch vorgesehen sein, dass beispielsweise die Anzahl der Windungen oder unterschiedliche Vorverstärkerempfindlichkeiten, die unabhängig von der Geometrie bzw. Form der Spule sind, aus der Sensitivität der jeweiligen Spule herausgerechnet werden. Als geringe Abnahme im Sinne der Erfindung kann eine Dämpfung von weniger als 6 dB, 12 dB, 18 dB oder 24 dB angesehen werden. Dies wird, wie in den nachfolgenden unabhängigen Ansprüchen näher ausgeführt, erreicht, indem Spulenwicklungen mit unterschiedlichen Abmessungen, insbesondere umschlossenen Flächen, zum Empfang der magnetischen Felder für den Empfang konfigurierbar sind.

Auf vorteilhafte Weise ermöglicht es die erfindungsgemäße Lokalspulenmatrix, ein magnetisches Wechselfeld mit unterschiedlichen auswählbaren Sensitivitätsbereichen zu detektieren und so mit der gleichen Lokalspule kleine Strukturen wie eine Hand oder auch tiefe Untersuchungen z.B. im Abdomen mit jeweils optimalem Signal-zu-Rausch-Verhältnis zu erfassen.

Vorteilhafte Ausführungsformen der erfindungsgemäßen Lokalspulenmatrix sind in den Unteransprüchen angegeben.

In einer denkbaren Ausführungsform der erfindungsgemäßen Lokalspulenmatrix weist die Lokalspulenmatrix eine erste Spulenwicklung und eine zweite Spulenwicklung auf.
Die erste Spulenwicklung weisen einen ersten Sensitivitätsbereiche auf und die zweiten Spulenwicklung einen zweiten Sensitivitätsbereich. Die unterschiedlichen Sensitivitätsbereiche können beispielsweise durch unterschiedliche Geometrien wie unterschiedlicher Durchmesser bzw. Umfang der Spulenwicklungen gegeben sein. Dabei ist der erste Sensitivitätsbereich eine Teilmenge des zweiten Sensitivitätsbereiches. Mit anderen Worten, der Bereich gleicher Empfindlichkeit bzw. Sensitivität auf ein magnetisches Wechselfeld der ersten Spulenwicklung ist kleiner als der Sensitivitätsbereich der zweiten Spulenwicklung und in dem Sensitivitätsbereich der zweiten Spulenwicklung im Wesentlichen erhalten. Das kann beispielsweise der Fall sein, wenn die erste Spulenwicklung eine kleinere Fläche umschließt als die zweite Spulenwicklung.

Zusätzlich müssen die Spulenwicklungen geeignet zueinander angeordnet sein, beispielsweise co-planar oder unter kleinem eingeschlossenen Winkel in benachbarten Ebenen derart angeordnet sind, dass die Projektion entlang der Flächennormalen der zweiten Spulenwicklung auf die erste Spulenwicklung diese umfasst, d.h. im Wesentlichen vollständig abdeckt. Als benachbart kann dabei ein Abstand angesehen werden, der kleiner als ein 0,1 faches, 0,2 faches oder 0,5 faches des Durchmessers bzw. der größten Abmessung der ersten Spulenwicklung ist. Es kann aber sein, dass beispielsweise zur Entkopplung von benachbarten ersten Spulen ein Überlapp vorhanden ist, der dann nicht durch die Projektion der Fläche der zweiten Spule abgedeckt ist, was durch den Begriff "im Wesentlichen" zum Ausdruck gebracht werden soll.

Im Übrigen ist es auch denkbar, dass mehrere Größenklassen von Spulenwicklungen kaskadiert werden, sodass zwischen den ersten Spulenwicklungen und den zweiten Spulenwicklungen eine weitere Klasse von Spulenwicklungen vorgesehen ist, die größere Abmessungen als die ersten Spulenwicklungen abdeckt und zu diesen in einem Verhältnis wie die zweiten Spulenwicklungen steht, während die weitere Klasse an Spulenwicklungen wiederum kleiner ist als die zweiten Spulenwicklungen, von diesen im Sensitivitätsbereich umfasst wird und in einem Verhältnis zu den zweiten Spulenwicklungen wie die ersten Spulenwicklungen steht.

Indem die erfindungsgemäße Lokalspulenmatrix die zu erfassende Fläche mit Spulenwicklungen unterschiedlicher Größe aufweist, kann für die Untersuchung auf vorteilhafte Weise ohne Wechsel der Lokalspulenmatrix eine Spulenwicklung mit am besten geeigneten Größe des Sensitivitätsbereichs gewählt werden und so die Bildqualität optimiert werden.

In einer möglichen Ausführungsform der erfindungsgemäßen Lokalspulenmatrix weist die Lokalspulenmatrix eine Mehrzahl an ersten Spulenwicklungen auf. Die einzelnen ersten Spulenwicklungen weisen jeweils erste Sensitivitätsbereiche auf. Eine Vereinigungsmenge der Projektionen der ersten Sensitivitätsbereiche auf die zweite Spulenwicklung umfasst dabei den zweiten Sensitivitätsbereich. Es ist beispielsweise denkbar, dass die ersten Spulenwicklungen co-planar in einer Ebene in einem Gitter oder Matrix so angeordnet sind, dass sich die Sensitivitätsbereiche überlappen. Eine zweite Spulenwicklung kann dann dazu in einer im wesentlichen parallelen Ebene in einem geringen Abstand, z.B. kleiner als der Durchmesser der ersten Spulenwicklungen, so angeordnet sein, dass die Projektion der ersten Spulenwicklungen auf die zweite Spulenwicklung die von der zweiten Spulenwicklung umschlossene Fläche vollständig abdecken. Mit anderen Worten, zumindest in einem Bereich in der Nähe der ersten Spulenwicklungen, die durch deren Sensitivitätsbereich definiert ist, insbesondere dessen Tiefe senkrecht zu der von der ersten Spulenwicklung umschlossenen Fläche, decken die ersten Spulenwicklungen den Bilderfassungsbereich der zweiten Spulenwicklung ab. Bis in einen durch den von dem Sensitivitätsbereich der ersten Spulen in die Tiefe beschränkten Bereich kann eine Bilderfassung wahlweise mit der zweiten Spulenwicklung oder mit den ersten Spulenwicklungen erfolgen.

So ermöglicht die erfindungsgemäße Lokalspulenmatrix, je nach Tiefe des zu untersuchenden Bereichs ohne eine an der Lokalspule anzuschließen, eine Spulenwicklung auszuwählen, die ein optimales Signal-zu-Rauschverhältnis aufweist und damit die Bildqualität verbessert oder die Untersuchung beschleunigt.

In einer denkbaren Ausführungsform der erfindungsgemäßen Lokalspulenmatrix weist die Lokalspulenmatrix eine Mehrzahl an zweiten Spulenwicklungen auf. Vorzugsweise bilden dabei die Mehrzahl der zweiten Spulenwicklungen eine Matrix oder ein Gitter aus, das mit den von den zweiten Spulenwicklungen umschlossenen Flächen einen zweidimensionalen Untersuchungsbereich im Wesentlichen abdeckt, d.h. bis auf Lücken, die kleiner als 20%, 10% oder 5 % der umschlossenen Fläche sind. Es sind dabei erste Spulenwicklungen vorgesehen, deren Sensitivitätsbereich Teilmenge des Sensitivitätsbereichs der jeweiligen zweiten Spulenwicklung ist. Vorzugsweise handelt es sich dabei um eine Mehrzahl an ersten Spulenwicklungen, die im Sinne des vorher erläuterten durch eine Vereinigungsmenge der Projektionen der ersten Sensitivitätsbereiche der ersten Spulenwicklungen auf die zweite jeweilige zugeordnete Spulenwicklung umfasst dabei den zweiten Sensitivitätsbereich der jeweiligen zweiten Spulenwicklung umfasst.

Auf vorteilhafte Weise ermöglicht die erfindungsgemäße Lokalspulenmatrix durch mehrere zweite Lokalspulenwicklungen größere Bereiche des Patientenbei einer Untersuchung zu erfassen.

In einer möglichen Ausführungsform der erfindungsgemäßen Lokalspulenmatrix sind dabei die von den zweiten Lokalspulen umschlossenen Flächen im Wesentlichen disjunkt. In anderen Worten, die von den zweiten Spulenwicklungen umschlossenen Flächen weisen im Wesentlichen keine Schnittmengen auf, d.h. bis auf überlappende Bereiche, die beispielsweise für eine Entkopplung benachbarter Spulenwicklungen vorgesehen sind.

Die disjunkten Flächen der zweiten Spulenwicklungen erlauben eine optimale Flächenabdeckung und reduzieren auf vorteilhafte Weise die Wechselwirkungen zwischen den zweiten Spulenwicklungen.

In einer denkbaren Ausführungsform der erfindungsgemäßen Lokalspulenmatrix weist die Lokalspulenmatrix eine Schaltmatrix mit ersten Signalanschlüssen und zweiten Signalanschlüssen auf. Die ersten der Signalanschlüsse stehen mit der Mehrzahl der Spulenwicklungen, d.h. mit den ersten Spulenwicklungen und der bzw. den zweiten Spulenwicklungen in Signalverbindung. Die Schaltmatrix ist ausgelegt, jeden der ersten mit mindestens einem der zweiten Signalanschlüsse in Signalverbindung zu schalten.

Als Signalverbindung kann dabei jede Signalverbindung angesehen werden, die geeignet ist, ein Magnetresonanzsignal zu übertragen. Dies kann eine analoge Verbindung, aber auch eine digitale Verbindung sein, elektrisch oder beispielsweise auch optisch. Denkbar ist es dabei, dass die Schaltmatrix nicht nur die Empfangssignale von der Spulenwicklung zu der Schaltmatrix, sondern auch umgekehrt Sendesignale zur Anregung von Kernspins zu der Spulenwicklung leitet.

Denkbar ist aber auch Schaltmatrix mit getrennten Schaltelementen für Sende- und Empfangsrichtung.

Es kann sich aber auch um eine digitale Schaltmatrix handeln, die bereits von einem der Spulenwicklung zugeordneten Analog-Digitalwandler digitalisierte Empfangssignale schaltet. Dabei ist auch denkbar, dass die Schaltmatrix auch ein zeitliches Multiplex zum Schalten verwendet und beispielsweise in Form einer Busstruktur realisiert ist.

Die zweiten Signalanschlüsse können dabei in Signalverbindung mit Steckverbindern stehen, die über Kabel eine Verbindung zu einem Empfänger, analog oder digital, herstellen. Die zweiten Signalanschlüsse können aber auch mit einer Übertragungseinrichtung zur drahtlosen Übertragung der Magnetresonanzsignale in Signalverbindung stehen, die vorzugsweise in der Lokalspulenmatrix bzw. deren Gehäuse vorgesehen ist.

Auf vorteilhafte Weise reduziert die Schaltmatrix die Anzahl der Verbindungen bzw. Kanäle zwischen der Lokalspulenmatrix und den Empfängern des Magnetresonanztomographen, da immer nur ein Teil der ersten und/oder zweiten Spulenwicklungen gleichzeitig zum Empfang bzw. zum Senden genutzt werden.

In einer möglichen Ausführungsform der erfindungsgemäßen Lokalspulenmatrix weist die Lokalspulenmatrix ein Koppelelement oder vorzugsweise mehrere Koppelelemente sowie eine Steuerung auf. Als Koppelelemente werden hierbei Schaltelemente angesehen, die aufgrund eines über eine Signalverbindung zwischen Steuerung und Koppelelement angelegten Steuersignals der Steuerung eine oder mehrere elektrische Verbindung herstellen und/oder auch öffnen können. Als elektrische Verbindung über das Koppelelement wird dabei eine Verbindung angesehen, bei der insbesondere ein Hochfrequenzsignal mit Larmorfrequenz eines bildgebenden Magnetresonanztomographen eine Dämpfung von weniger als 3 dB, 6 dB oder 12 dB erfährt. Die elektrische Verbindung ist im Sinne der Erfindung gelöst, wenn das Hochfrequenzsignal bei Durchgang durch das geöffnete Koppelelement um mehr als 18 dB, 24 dB, 36 dB oder 60 dB gedämpft wird. Koppelelemente können beispielsweise durch Relais, mikromechanische Schalter, PIN-Dioden oder Transistoren realisiert werden. Denkbar sind auch Kombinationen mehrerer Schaltelemente zu einem Koppelelement, beispielsweise, um eine Verbindung schließen und gleichzeitig eine andere Verbindung öffnen zu können, oder um gleichzeitig mehrere Verbindungen bereitzustellen.

Das Koppelelement bzw. die Koppelelemente stehen jeweils mit mindestens zwei Spulensegmenten in Signalverbindung und die Steuerung ist ausgelegt, die mindestens zwei Spulensegmente mit Hilfe des Koppelelements bzw. der Koppelelemente zu verbinden bzw. zu trennen. Dabei ist es denkbar, dass erst durch das Aktivieren eines ersten Schaltzustandes eines Koppelements eine Spulenwicklung in dem Sinne gebildet wird, dass eine geschlossene elektrisch Verbindung für ein Hochfrequenzsignal mit Larmorfrequenz zwischen zwei benachbarten Anschlussstellen um eine umschlossene Fläche gebildet wird, sodass durch ein magnetisches Wechselfeld mit Larmorfrequenz durch die Fläche ein Magnetresonanzsignal an den Anschlussstellen induziert wird bzw. umgekehrt durch zuführen eines Sendesignals an den Anschlussstellen ein magnetisches Wechselfeld durch die umschlossene Fläche erzeugt wird. Das Aktivieren eines zweiten Schaltzustandes durch die Steuerung kann beispielsweise eine elektrische Verbindung wieder gelöst bzw. geöffnet werden. Dabei können erster und zweiter Schaltzustände je nach Verschaltung der Koppelelemente und der Spulensegmente beispielsweise der geöffnete oder der geschlossene Zustand sein oder auch ein Wechsel zwischen zwei elektrischen Verbindungen.

Auf vorteilhafte Weise erlaubt es die erfindungsgemäße Lokalspulenmatrix durch die Koppelelemente, variabel unterschiedliche Spulenwicklungen aus den Spulensegmenten zu schalten und so die Sensitivitätsbereiche zur Optimierung der Bilderfassung flexibel anpassen kann.

In einer möglichen Ausführungsform der erfindungsgemäßen Lokalspulenmatrix ist das Spulensegment selbstresonant bei der Larmorfrequenz ausgebildet. Darunter ist zu verstehen, dass das Spulensegment allein, d.h. ohne Verschaltung mit anderen Spulensegmenten bereits bei der Larmorfrequenz eine Resonanz aufweist. Dies kann beispielsweise erreicht werden, indem das bzw. jedes Spulensegment ein oder mehrere Bauelemente mit komplexem Widerstand aufweist, der in Zusammenwirken mit dem Spulensegment eine Resonanz erzeugt. Dieses kann je nach Verschaltung beispielsweise eine Kapazität und/oder eine Induktivität sein. Denkbar sind auch Wellenleiter mit offenem oder kurzgeschlossenen Enden und einer angepassten Länge, beispielsweise Microstripleitungen oder Koaxialkabelabschnitte.

Denkbar wäre es aber auch, dass das bzw. die Bauelemente Teil des Koppelelements sind und beim Zusammenschalten mit dem Spulensegment jeweils ein selbstresonantes Element bei der Larmorfrequenz des Magnetresonanztomographen bilden.

Auf vorteilhafte Weise ermöglichen es die selbstresonanten Spulensegmente, dass auch beliebige Zusammenschaltungen der Spulensegmente mittels der Koppelelemente zu Spulenwicklungen mit unterschiedlicher Geometrie jeweils wiederum bei der Larmorfrequenz resonant sind.

In einer möglichen Ausführungsform der erfindungsgemäßen Lokalspulenmatrix weist die Lokalspulenmatrix eine Vielzahl an Spulensegmenten auf. Dabei spannen die Spulensegmente ein zweidimensionales Netz aus Polygonen auf. Es ist beispielsweise denkbar, dass die Spulensegmente jeweils die Seiten eines Dreiecks, Vierecks oder Hexagons bilden, die sich in einem Knotenpunkt treffen und die zu einem geschlossenen Netzwerk mechanisch verbunden sind, das eine zweidimensionale Fläche bildet. Dabei sind auch jeweils Gebilde gleicher Topologie als Dreiecke, Vierecke oder Hexagon im Sinne der Erfindung anzusehen, bei denen die Verbindungen zwischen den Ecken bzw. Knotenpunkten nicht gerade sondern gekrümmt verlaufen-Denkbar sind auch Netzwerke aus Polygonen mit unterschiedlichen Seitenzahlen.

Auf vorteilhafte Weise können aus Spulensegmenten 2-dimensionale flächige Gebilde zusammengestellt werden, die eine Oberfläche, beispielsweise über einem Patienten vollständig abdecken.

In einer denkbaren Ausführungsform der erfindungsgemäßen Lokalspulenmatrix ist eine Vielzahl an Knotenpunkten mit einem Koppelelement besetzt ist.

Als Knotenpunkt im Sinne der Erfindung werden die Punkte des Netzwerkes aus Polygonen bezeichnet, an denen sich mehr als zwei Spulensegmente treffen. Dabei ist es denkbar, dass die Spulensegmente an diesen Knoten miteinander auf nicht durch Konfiguration veränderbare Weise elektrisch verbunden sind, beispielsweise ohmsch, durch eine Kapazität oder Induktivität. Bei einer Vielzahl an Knoten ist dabei jedoch ein Koppelement vorgesehen, dass je nach Schaltzustand eine andere elektrische Verbindung zwischen den Spulensegmenten an diesem Knotenpunkt herstellt. Als Vielzahl kann mehr als 10%, 30%, 50% oder 80% der Knoten in dem Netzwerk angesehen werden. Das Koppelelement ist dabei ausgelegt, mindestens zwei der an dem Knoten angrenzenden Spulensegmente lösbar elektrisch zu verbinden.

Die Vielzahl der Koppelelemente erlaubt es, aus dem Netzwerk der Spulensegmente durch Konfiguration unterschiedliche Spulenwicklungen zu bilden und so die Lokalspulenmatrix an unterschiedliche Untersuchungen flexibel bezüglich der Spulengröße und Form anzupassen.

In einer möglichen Ausführungsform weist dabei die Lokalspulenmatrix auch eine bereits dargestellt Schaltmatrix auf, die mit den ersten Signalanschlüssen derart mit den Spulensegmenten verbunden ist, dass die durch die Koppelelemente geschalteten Spulenwicklungen mit den zweiten Signalanschlüssen durch die Steuerung wahlfrei verbindbar sind.

Das erfindungsgemäße Verfahren betrifft den Betrieb eines Magnetresonanztomographen mit einer erfindungsgemäßen Lokalspulenmatrix, wie sie vorhergehend beschrieben wurde. Dabei weist das Verfahren den Schritt auf, einen Scanparameter für eine Bilderfassung durch den Magnetresonanztomographen zu ermitteln. Als Scanparameter wird eine Einstellung des Magnetresonanztomographen betrachtet, die das mit diesem Scanparameter erfasste Bild verändert. Beispiele für Scanparameter werden nachfolgend in den Unteransprüchen erläutert. Als Ermitteln im Sinne der Erfindung kann ein einfaches Auslesen des Scanparameters aus einem Speicher des Magnetresonanztomographen oder auch ein Bestimmen durch eine Magnetresonanzmessung oder mit einem weiteren Sensor angesehen werden.

In einem weiteren Schritt des erfindungsgemäßen Verfahrens ermittelt der Magnetresonanztomograph eine Konfiguration der Lokalspulenmatrix in Abhängigkeit von dem Scanparameter. Eine Konfiguration gibt dabei die Geometrie und/oder Auswahl der für eine nachfolgende Bilderfassung zu verwendenden Spulenwicklungen der Lokalspulenmatrix vor. Dies kann beispielsweise durch eine Einstellung der Schaltmatrix und/oder Einstellung der Koppelelemente umfassen.

In einem weiteren Schritt des erfindungsgemäßen Verfahrens stellt der Magnetresonanztomograph die Lokalspulenmatrix gemäß der ermittelten Konfiguration ein. Beispielsweise kann der Magnetresonanztomograph bzw. dessen Steuerung Einstellbefehle an die Schaltmatrix und/oder Koppelelemente über eine Signalverbindung senden, die in der Lokalspulenmatrix Verbindungen gemäß der Konfiguration schalten.

In einem anderen Schritt des erfindungsgemäßen Verfahrens führt der Magnetresonanztomograph eine Bilderfassung mit Hilfe der Lokalspulenmatrix aus. Es ist dabei denkbar, dass die Lokalspulenmatrix dabei als Empfangs- und/oder Sendespule verwendet wird.

Das erfindungsgemäße Verfahren ermöglicht auf vorteilhafte Weise, mit der erfindungsgemäßen Lokalspulenmatrix einfacher und schneller, ohne manuelle Einstellungen der Lokalspulenmatrix, eine Bilderfassung durchzuführen.

In einer Ausführungsform des erfindungsgemäßen Verfahrens weist der Scanparameter Information zu einer Anordnung der Lokalspulenmatrix relativ zu dem Patienten und/oder Magnetresonanztomographen, Beschleunigungsfaktoren innerhalb einer Schicht , sowie bei Mehrschichtabtastung, Geometrie des zu untersuchenden Bereichs, Art der zu erzeugenden Abbildung (z.B. 2D oder 3D) oder Phasenkodier-Richtung auf. Denkbar sind auch Scanparameter, die bei der Bilderfassung durch die Geometrie oder Sensitivitätsbereiche der Spulenwicklungen der Lokalspulenmatrix beeinflusst werden.

Auf vorteilhafte Weise werden durch das erfindungsgemäße Verfahren anwendungsorientierte Randbedingungen schnell und unter Vermeidung von Fehlern in technische Einstellungen der Lokalspulenmatrix umgesetzt.

In einer denkbaren Ausführungsform des erfindungsgemäßen Verfahrens weist der Schritt des Ermittelns des Scanparameters ein Aufnehmen und Auswerten eines Pre-Scans auf. Als Pre-Scan wird dabei eine Magnetresonanzmessung bezeichnet, die schneller und/oder mit geringerer Belastung für den Patienten ausgeführt wird und zur Ermittlung eines Scanparameters für eine nachfolgende Bilderfassung geeignet ist. Ein Pre-Scan kann beispielsweise eine Bilderfassung mit geringerer Auflösung, schlechterem SNR oder geringerer Dimensionalität (2D, 1D) umfassen. Denkbar sind aber auch andere Hochfrequenzmessungen, die beispielsweise eine Überlappungen von Spulenwicklungen oder eine Geometrie der Anordnung der Lokalspulenmatrix (flach ausgelegt oder z.B. um den Patienten oder um Gliedmaßen gewickelt, gefaltet) z.B. durch Verstimmung, Dämpfung oder schlechteres SNR erkennen.

Auf vorteilhafte Weise können mittels eines Pre-Scans Daten zur Gewinnung eines Scan-Parameters erfasst werden, die eine schnelle und sichere Einstellung der Lokalspulenmatrix für eine nachfolgende Bilderfassung sicherstellen.

In einer möglichen Ausführungsform des erfindungsgemäßen Verfahrens weist der Schritt des Ermittelns des Scanparameters das Ermitteln des Untersuchungsparameters ein Erfassen einer Position der Lokalspulenmatrix relativ zu dem Patienten auf. Denkbar ist beispielsweise, dass eine Kamera oder ein anderer Sensor die Lage der Lokalspulenmatrix relativ zu dem Patienten erfasst oder die Position mittels eines Pre-Scans bildbasiert ermittelt wird.

Auf vorteilhafte Weise kann durch die Kenntnis der Lage der Lokalspulenmatrix zu dem Patienten einfach bestimmt werden, wie die Lokalspulenmatrix konfiguriert werden muss, um einen vorbestimmten Untersuchungsbereich, beispielsweise Herz oder Leber, bei einer Magnetresonanzmessung erfassen zu können.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine beispielhafte schematische Darstellung eines Magnetresonanztomographen mit einer erfindungsgemäßen Hochfrequenzansteuerung;
- Fig. 2: eine schematische Darstellung von Spulenwicklungen einer ersten Ausführungsform einer erfindungsgemäßen Lokalspulenmatrix;
- Fig. 3: eine schematische Darstellung einer anderen Ausführungsform einer erfindungsgemäßen Lokalspulenmatrix;
- Fig. 4: eine schematische Darstellung für Konfigurations-beispiele der anderen Ausführungsform einer erfindungsgemäßen Lokalspulenmatrix;
- Fig. 5: eine schematische Darstellung einer anderen Ausführungsform einer erfindungsgemäßen Lokalspulen-matrix;
- Fig. 6: eine schematische Darstellung einer anderen Ausführungsform einer erfindungsgemäßen Lokalspulen-matrix;
- Fig. 7: eine schematische Darstellung eines Koppelements einer erfindungsgemäßen Lokalspulenmatrix;
- Fig. 8: eine schematische Darstellung von Schaltkonfigurationen des Koppelelements;
- Fig. 9: eine schematische Darstellung eines Koppelements einer erfindungsgemäßen Lokalspulenmatrix;
- Fig. 10: eine schematische Darstellung von Schaltkonfigurationen des Koppelelements;
- Fig. 11: einen schematischen Ablaufplan eines beispielhaften erfindungsgemäßen Verfahrens.

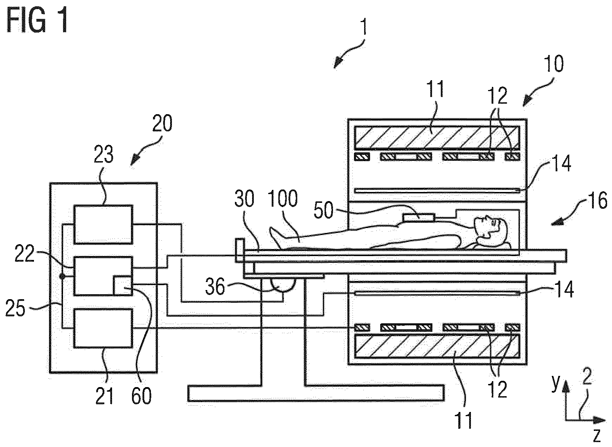

Fig. 1 zeigt eine schematische Darstellung einer Ausführungsform eines erfindungsgemäßen Magnetresonanztomographen 1 mit einer erfindungsgemäßen Lokalspulenmatrix 50.

Die Magneteinheit 10 weist einen Feldmagneten 11 auf, der ein statisches Magnetfeld B0 zur Ausrichtung von Kernspins von Proben bzw. Patienten 100 in einem Aufnahmebereich erzeugt. Der Aufnahmebereich ist in einem Patiententunnel 16 angeordnet, der sich in einer Längsrichtung 2 durch die Magneteinheit 10 erstreckt. Ein Patient 100 ist mittels der Patientenliege 30 und der Verfahreinheit 36 der Patientenliege 30 in den Aufnahmebereich verfahrbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung 33 zugeführtes Hochfrequenzsignal in das Untersuchungsvolumen abzustrahlen und von dem Patient 100 emittierte Resonanzsignale zu empfangen und über eine Signalleitung abzugeben. Bevorzugter Weise wird aber die Körperspule 14 für das Aussenden des Hochfrequenzsignals und/oder das Empfangen durch die Lokalspulenmatrix 50 ersetzt, die in dem Patiententunnel 16 nahe am Patient 100 angeordnet sind. Es ist aber auch denkbar, dass die Lokalspulenmatrix 50 zum Senden und Empfangen ausgelegt ist und deshalb eine Körperspule 14 entfallen kann.

Eine Steuereinheit 20 versorgt die Magneteinheit 10 mit den verschiedenen Signalen für die Gradientenspulen 12 und die Körperspule 14 und wertet die empfangenen Signale aus. Eine Magnetresonanztomographen-Steuerung 23 koordiniert dabei die Untereinheiten.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die einzelnen Einheiten sind über einen Signalbus 25 untereinander verbunden.

Das von Hochfrequenzeinheit 22 erzeugte Hochfrequenzsignal wird über eine Signalverbindung der Körperspule 14 zugeführt und in den Körper des Patienten 100 ausgesendet, um dort die Kernspins anzuregen. Denkbar ist aber auch ein Aussenden des Hochfrequenzsignals über eine oder mehrere Spulenwicklungen der Lokalspulenmatrix 50.

Die Lokalspulenmatrix 50 empfängt dann vorzugsweise ein Magnetresonanzsignal aus dem Körper des Patienten 100, denn aufgrund des geringen Abstandes ist das Signal-zu-Rauschverhältnis (SNR) der Lokalspulenmatrix 50 besser als bei einem Empfang durch die Körperspule 14. Das von der Lokalspulenmatrix 50 empfangene MR-Signal wird in der Lokalspulenmatrix 50 aufbereitet und an die Hochfrequenzeinheit 22 des Magnetresonanztomographen 1 zur Auswertung und Bilderfassung weitergeleitet. Vorzugsweise wird dazu die Signalverbindung 33 genutzt, es ist aber beispielsweise auch eine drahtlose Übertragung denkbar.

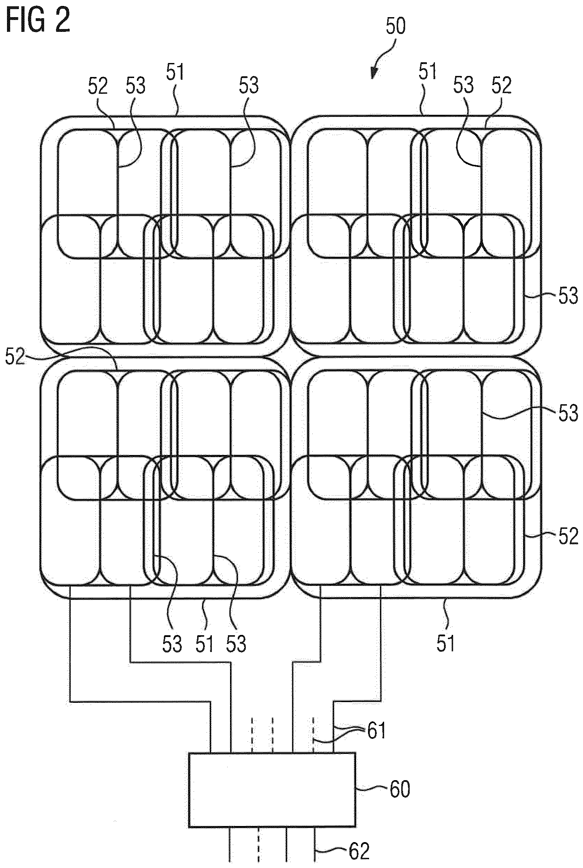

In Fig. 2 ist eine beispielshaften Ausführungsform der erfindungsgemäßen Lokalspulenmatrix 50 mit Spulenwicklungen 51, 52, 53 schematisch dargestellt. Die Spulenwicklungen 51, 52 und 53 unterscheiden sich in der Größe der von ihnen umschlossenen Fläche. Die größten Spulenwicklungen 51 umschließen jeweils eine Fläche, die wiederum durch die Vereinigungsmenge der von den mittleren Spulenwicklungen 52 umschlossenen Flächen ebenfalls abgedeckt wird. Mit anderen Worten, eine große Spulenwicklung 51 bedeckt mit der umschlossenen Fläche die gleiche Fläche wie die umschlossenen Flächen einer Mehrzahl mittlerer Spulenwicklungen 52 (im Beispiel 2). Bedecken kann zunächst im bildlichen Sinne verstanden werden, wesentlich im Sinne der Erfindung ist jedoch, dass die Spulen aufgrund der geometrischen Bedeckung eine Sensitivität für Magnetresonanzsignale innerhalb dieser Fläche bzw. Flächen in einem räumlichen Bereich entlang einer Flächennormale zu diesen Flächen aufweisen. Dabei bewirkt die Überdeckung der Flächen, dass ein Magnetresonanzsignal einer Quelle unter der größten Spulenwicklung 51 immer auch von zumindest einer der mittleren Spulen 52 erfasst werden kann, soweit es nicht entlang der Flächennormale zu weit von den umschlossenen Flächen entfernt ist, um von der mittleren Spulenwicklung 52 noch erfasst zu werden. Als Erfassen kann dabei angesehen werden, dass ein Magnetresonanzsignal, das in einer mittleren Annenspule 52 eine Spannung induziert, eine um höchstens 3dB, 6dB oder 12 dB höhere Spannung in der größten Spulenwicklung 51 erzeugt.

Das gleiche gilt auch für die Beziehung der kleinsten Spulenwicklungen 53 zu den mittleren Spulenwicklungen 52 und den größten Spulenwicklungen 51. In der beispielhaften Ausführungsform bedecken jeweils 4 kleinste Spulenwicklungen 53 die gleiche Fläche wie eine mittlere Spulenwicklung 52 und 8 kleinste Spulenwicklungen 53 die Fläche einer größten Spulenwicklung 51. Zumindest für Untersuchungsbereiche nahe der Lokalspulenmatrix 50, d.h. mit einem Abstand von der Lokalspulenmatrix 50, der kleiner als die Tiefe des Sensitivitätsbereichs der kleinsten Spulenwicklung 53 ist, kann ein Magnetresonanzsignal wahlweise mit einer größten Spulenwicklung 51, einer mittleren Spulenwicklung 52 oder einer kleinsten Spulenwicklung 53 erfasst werden. Vorzugsweise wird dabei jeweils die Spulenwicklung mit dem kleinstmöglichen Sensitivitätsbereich, d.h. auch umschlossenen Fläche, zum Empfang genutzt, mit der (wegen der Tiefe) das Magnetresonanzsignal noch erfasst werden kann, denn dadurch verbessert sich das Signal-zu-Rausch-Verhältnis. Es sind aber auch andere Anwendungen denkbar, bei denen z.B. ein großes Volumen nur schnell abgetastet werden soll oder bei denen unterschiedliche räumliche Sensitivitätsbereiche wünschenswert sind.

In der Fig. 2 überlappen auch jeweils benachbarte mittlere Spulenwicklungen 52 und benachbarte kleinste Spulenwicklungen 53 in den Randbereichen miteinander, um benachbarte Spulenwicklungen zu entkoppeln. Es wäre aber auch denkbar, die Spulenwicklungen gleicher Größe jeweils disjunkt anzuordnen und die Entkopplung mit anderen Maßnahmen, z.B. durch Entkopplungskondensatoren, zu erreichen.

Denkbar ist es dabei auch, dass eine Lokalspulenmatrix nur zwei Ebenen an Spulenwicklungen unterschiedlicher Größe Aufweist, beispielsweise nur größte Spulenwicklungen 51 und kleinste Spulenwicklungen 53, oder noch mehrere unterschiedliche Größenklassen, wobei zumindest jeweils 2 Größenklassen wie z.B. zu den größten Spulenwicklungen 51 und den mittleren Spulenwicklungen 52 zuvor dargelegt, einander überdecken

In Fig. 2 ist auch eine Schaltmatrix 60 der Lokalspulenmatrix 50 dargestellt, die in Signalverbindung mit jeder der größten Spulenwicklungen 51, der mittleren Spulenwicklungen 52 und der kleinsten Spulenwicklungen 53 an n ersten Signalanschlüssen 61 steht, Der Übersichtlichkeit halber sind nicht alle Signalverbindungen in der Fig. 2 dargestellt. An n zweiten Signalanschlüssen 62 besteht eine Signalverbindung, beispielsweise über Kabel oder drahtlos, zu dem Magnetresonanztomographen 1. Die Schaltmatrix 60 ist dabei ausgelegt, von jedem der m ersten Signalanschlüsse 61 zumindest mit einem zweiten Signalanschluss 62 eine Signalverbindung schalten zu können. Vorzugsweise ist dabei m > n, sodass die Anzahl der Signalverbindungen zum Magnetresonanztomographen 1 geringer ist und nur die Signale der aktuell zur Erfassung benötigten Spulenwicklungen weitergeleitet werden. Als Schalter in der Schaltmatrix können beispielsweise Relais, Transistoren, PIN-Dioden oder MEMS-Schalter verwendet werden. Denkbar ist es dabei auch, dass die Schaltmatrix 60 nicht nur Empfangssignale von den Spulenwicklungen zu Empfängern des Magnetresonanztomographen leitet, sondern umgekehrt auch Sendesignale zur Anregung der Kernspins von einem Sender des Magnetresonanztomographen 1 zu den Spulenwicklungen.

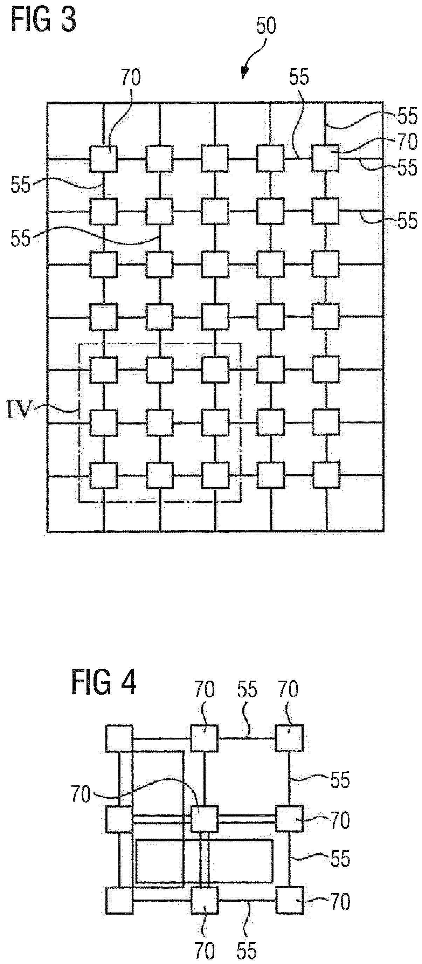

Fig. 3 zeigt eine schematische Darstellung einer anderen Ausführungsform einer erfindungsgemäßen Lokalspulenmatrix 50. Diese Ausführungsform weist eine Vielzahl an Spulensegmenten 55 auf, die in einem Gitter angeordnet sind. Als Spulensegmente 55 werden dabei elektrische Leiter angesehen, die eine Längserstreckung aufweisen und die durch Zusammenfügen mittels elektrischer Verbindungen zu einer Spulenwicklung für Hochfrequenzsignale mit einer Larmorfrequenz des Magnetresonanztomographen 1 zusammenfügbar sind. Dies können beispielsweise Abschnitte gut leitender Drähte oder Hochfrequenzlitzen, aber auch Leiterbahnen auf flexiblen oder starren Trägermaterialien für Hochfrequenzschaltungen sein. Vorzugsweise weisen die Trägermaterialien dabei geringe dielektrische Verluste auf. Die Leiter können dabei in geeignete Isoliermaterialien eingebettet sein. Denkbar sind als Leiter auch exotische Materialien wie Supraleiter, Hochtemperatursupraleiter, Kohlenstoffnanoröhrchen oder Graphen.

Die Spulensegmente 55 sind derart durch Koppelelemente 70 miteinander verbunden, dass über mehrere Spulensegmente 55 durch ein oder mehrere Koppelelemente 70 eine elektrisch durchgehende Leiterschleife herstellbar ist, die zum Erzeugen oder Empfangen eines Magnetresonanzsignals geeignet ist. Die Koppelemente 70 können dazu wie nachfolgend dargelegt verschiedene Arten von steuerbaren Schaltelementen aufweisen, die von einer Steuerung 80 angesteuert, über Signalverbindungen angesteuert werden.

In Fig. 4 ist eine schematische Darstellung für Konfigurationsbeispiele der Lokalspulenmatrix 50 angegeben, wie sie mit unterschiedlichen Einstellungen der Koppelelemente 60 erzielt werden können. Durch geeignetes Verbinden der einzelnen Spulensegmente 55 durch die Koppelelemente 60 kann zum Beispiel eine im inneren angedeutete, aufrecht stehende Form einer Spulenwicklung geschaltet werden, die die Außenumgrenzung eines aus den zwei linken Quadraten gebildeten Rechtecks umfasst. Ebenso kann beispielsweise eine Spulenwicklung in Form des liegenden Rechtecks geschaltet werden.

Ebenfalls nicht in Fig. 3 und 4 dargestellt sind Signalverbindungen, über die die Spulenwicklung Empfangssignale weiter zum Magnetresonanzempfänger leitet oder zum Aussenden von diesem erhält. Diese Signalverbindungen können entweder direkt an eine Mehrzahl der Spulensegmente 55 direkt angeschlossen sein. Es ist aber auch denkbar, dass die Signalverbindungen an einer Mehrzahl an Koppelelementen 70 vorgesehen sind, sodass diese Verbindungen schaltbar sind. Damit können die Koppelelemente 70 gleichzeitig eine Funktion vergleichbar der Schaltmatrix 60 übernehmen, indem sie aus einer Mehrzahl von anliegenden Spulensegmente eines zum Verbinden auswählen und so eine Leiterschleife, in die das Spulensegment 55 und das Koppelelement 70 durch Konfiguration eingebunden sind, steuerbar mit dem Magnetresonanztomographen verbinden. Auf diese Weise kann allein durch die Koppelelemente 70 die Anzahl der Signalverbindungen zwischen Lokalspulenmatrix 50 und Magnetresonanztomograph 1 kleiner als die Zahl der konfigurierbaren Spulenwicklungen aus Koppelelementen 70 und Spulensegmenten 55 gehalten werden. Beispiele hierzu sind nachfolgend näher erläutert.

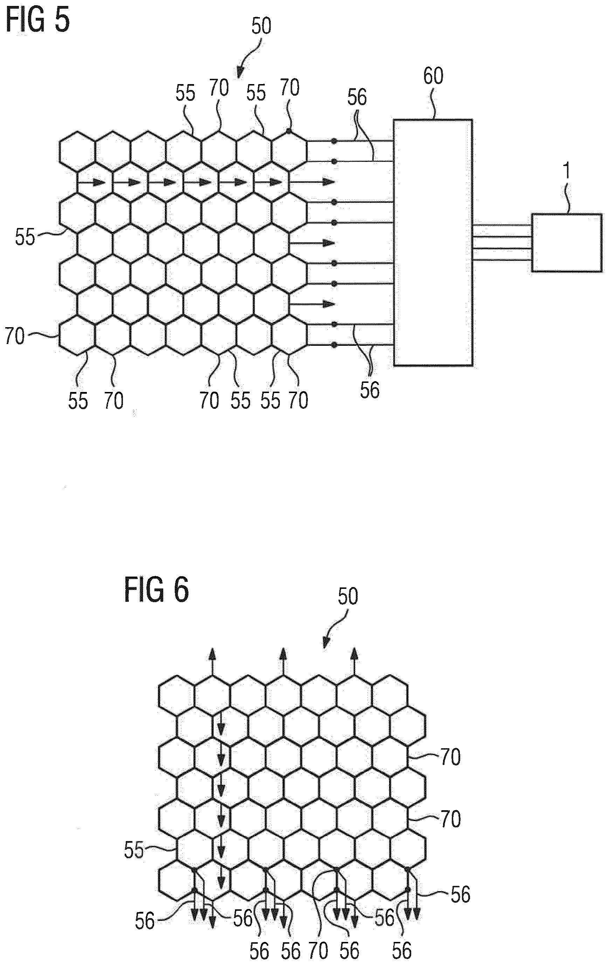

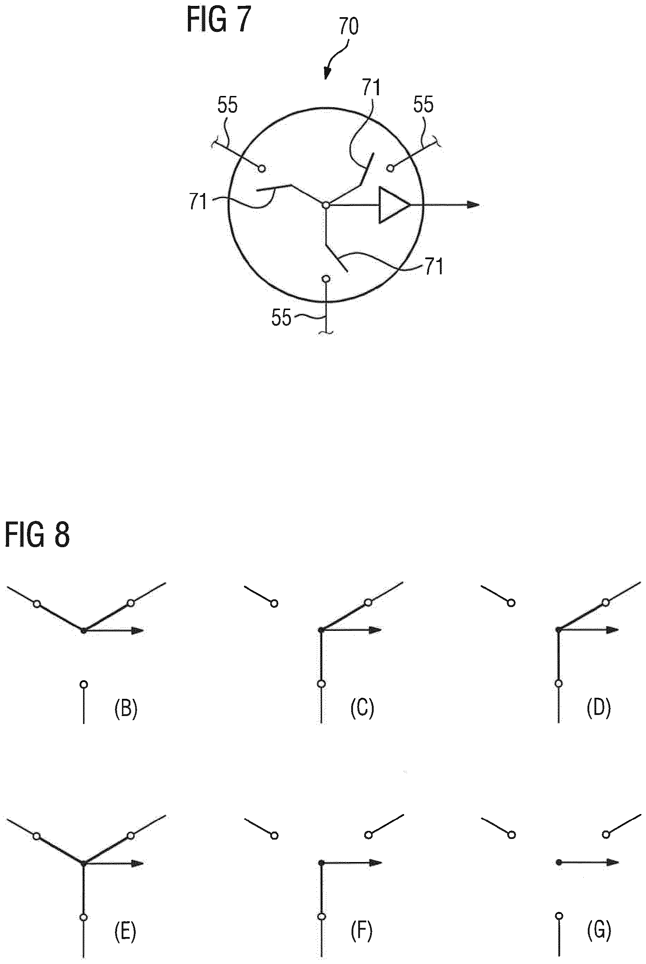

In Fig. 5 ist eine weitere Ausführungsform einer erfindungsgemäßen Lokalspulenmatrix dargestellt. Die Lokalspulenmatrix 50 in Fig. 5 unterscheidet sich von der Ausführungsform der Fig. 4 darin, dass die Spulensegmente 55 und Koppelelemente 70 nicht ein Gitter mit quadratischen Grundelementen bilden, sondern ein hexagonales Gitter. Der wesentliche Vorteil des hexagonalen Gitters ist es, dass an jedem Knoten, nur jeweils vier Spulensegmente 55 zusammentreffen. Ein an einem Knoten angeordnetes Koppelelement 70 benötigt daher maximal drei Schaltelemente, wie nachfolgend in Fig. 7 dargestellt ist, um flexibel alle Spulensegmente 55 miteinander verbinden zu können. In Fig. 5 ist weiterhin eine Schaltmatrix 60 dargestellt, die mit jeweils zwei benachbarten Koppelelementen 70 in Signalverbindung 56 steht.

Mit den dargestellten Signalverbindungen 56 zu den Koppelementen 70 wäre es beispielsweise möglich, die Spulensegmente zu länglichen Spulenwicklungen zu verschalten und dann über die Schaltmatrix 60 zu verbinden, sodass zeilenweise über den Untersuchungsbereich Spulenwicklungen angeordnet sind. Und beispielsweise eine schichtweise Abtastung möglich wäre.

In Fig. 6 ist eine entsprechende Lokalspulenmatrix 50 mit Signalverbindungen 56 dargestellt, die eine Abtastung mit länglichen, vertikal angeordneten Spulenwicklungen erlauben würde.

Denkbar sind auch Mischformen mit vertikaler und horizontaler Anbindung an den Rändern der Lokalspulenmatrix 55. Eine besonders flexible Konfiguration erlaubt eine aus Gründen der Übersichtlichkeit nicht dargestellte Ausführungsform, bei der die Signalverbindungen 56 zwischen Schaltmatrix 60 und Koppelelementen 70 flächig über die Lokalspulenmatrix verteilt sind. Dabei sind vorzugsweise nicht alle, sondern nur ein Teil, beispielsweise 50%, 30%, 10% oder weniger der Koppelelemente 70 oder Spulensegmente 55 mit einer Signalverbindung 56 zu der Schaltmatrix 60 versehen. Die Verteilung kann gleichmäßig oder nach einem willkürlichen Muster erfolgen. Eine derartige Verteilung ermöglicht es, über die Fläche mit unterschiedlich großen Spulenwicklungen eine Magnetresonanzmessung vorzunehmen.

In Fig. 7 ist ein beispielhaftes Koppelelement 70 einer erfindungsgemäßen Lokalspulenmatrix 50 dargestellt. Das Koppelelement 70 ist mit drei Spulensegmenten 55 verbunden, zwischen denen es eine mittels Schaltelementen 71 eine Verbindung herstellen kann. Denkbar sind aber auch andere geometrische Konfigurationen der Koppelmatrix, bei denen mehr als drei Spulensegmente 55 an einem Koppelelement zusammentreffen, sodass das Koppelelement 70 entsprechend Schaltelemente 71 aufweist.

Nicht dargestellt in Fig. 7 ist eine Steuerleitung, mittels derer das Koppelelement 70 bzw. die Schaltelemente 71 gesteuert werden. Denkbar ist es, dass die Schalter direkt durch separate Ansteuerleitungen mittels einer Spannung und/oder eines Stromes angesteuert werden, wie es beispielsweise bei PIN-Dioden oder Transistoren möglich ist. Wegen der dafür erforderlichen vielen Steuerleitungen, die das magnetische Wechselfeld stören, werden aber vorzugsweise intelligente Schaltelemente 71 verwendet, die es erlauben, über eine oder wenige Leitungen mehrere Koppelelemente bzw. Schaltelemente zu steuern. Denkbar wäre es beispielsweise, eine Busleitung zu verwenden, die eine Mehrzahl oder alle Koppelelemente 70 mit einer Steuerung des Magnetresonanztomographen 1 verbindet und so eine Konfiguration der Lokalspulenmatrix 50 bei einer Magnetresonanztomographie ermöglicht. Die Busleitung könnte dabei die Energieversorgung und die Ansteuerung übernehmen, indem einer Gleich- oder Wechselspannung ein Steuersignal mit Adressen und Steuerbefehlen aufmoduliert wird. Es wäre auch denkbar, durch Trennung der Frequenzen die Signalverbindung 56 für die Magnetresonanzsignale auch für die Energieversorgung und ein Steuersignal zu verwenden. Insbesondere bei einer Digitalisierung des Magnetresonanzsignals bereits durch einen AD-Wandler in dem Koppelement 70 ist eine gemeinsame Nutzung der Signalverbindung 56 auch für Steuersignale denkbar.

In Ausführungsform der Fig. 7 stehen die Schaltelemente 71 an einem gemeinsamen Punkt sternförmig in Signalverbindung, von dem aus auch die Signalverbindung 56 zu der Schaltmatrix 60 und/oder dem Magnetresonanztomographen 1 besteht.

Die Fig. 8 gibt mögliche Schaltkonfigurationen des in Fig. 7 dargestellten Koppelelements 70 an. Die Variationen reichen von einer Öffnung aller Schaltelemente 71 in G, bei der alle anliegenden Spulensegmente 55 voneinander getrennt sind, über die Verbindung eines einzelnen Spulensegments 55 mit der Signalverbindung 56 in F oder einer Verbindung zweier Spulensegmente 55 miteinander und mit der Signalverbindung 56 wie in B, C und D hin zu einer Verbindung aller anliegenden Spulensegmente 55 untereinander und mit der Signalverbindung 56 wie in E.

Natürlich sind auch andere Koppelelemente 70 vorstellbar. Beispielsweise könnten die drei Schaltelemente 71 auch in den Seiten eines Dreiecks angeordnet sein, dessen Ecken jeweils mit einem Spulensegment verbinden sind.

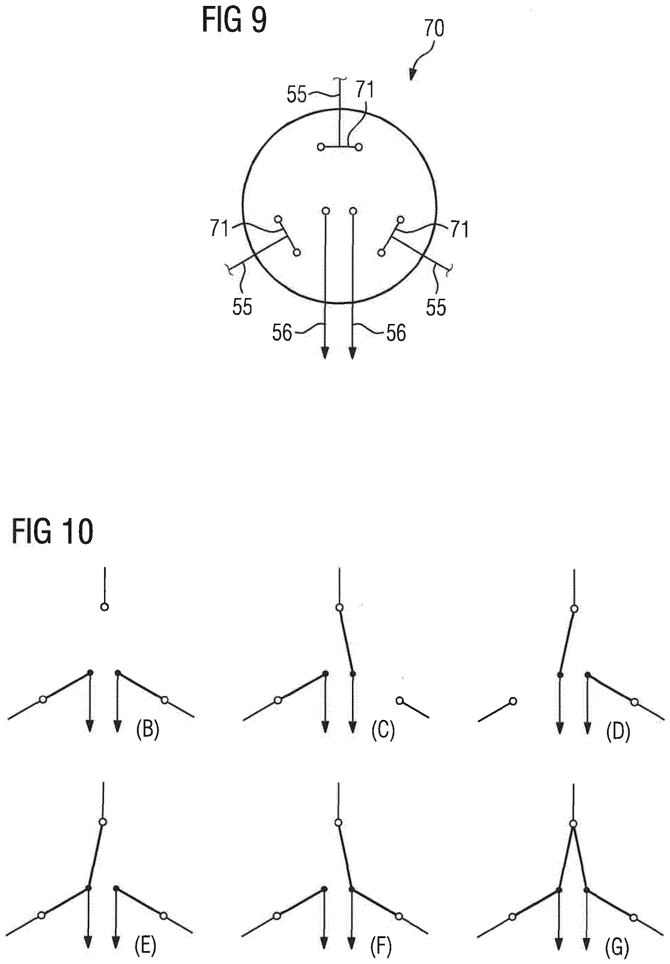

In Fig. 9 ist eine weitere mögliche Ausführungsform für ein Koppelelement 70 angegeben. Dabei ist jedes der drei am Koppelelement 70 angeschlossenen Spulensegmente 55 mit einem Schaltelement 71 versehen. Weiterhin weist das Koppelelement 70 zwei voneinander unabhängige Signalverbindungen 56 zu der Schaltmatrix 60 und/oder dem Magnetresonanztomographen 1 auf. Was die Ansteuerung der Schaltelemente 71 angeht, sei auf die Ausführungen zu Fig. 7 und 8 verwiesen.

In Fig. 10 sind unterschiedliche mögliche Schalteinstellungen der Schaltelemente 71 des Koppelelements aus Fig. 9 angegeben. Gegenüber dem Koppelement 70 aus Fig. 7 und 8 ermöglicht es das Koppelelement 70 in Fig. 9 und 10 durch die zwei Signalverbindungen 56, aus den anliegenden Spulenelementen 55 in Verbindung mit anderen Koppelelementen 70 und Spulensegmenten 55 zwei unmittelbar angrenzende Spulenwicklungen bereitzustellen und mit dem Magnetresonanztomographen 1 zu verbinden.

Auch die Lokalspulenmatrices 50 der Fig. 3 bis Fig. 10 ermöglichen es durch unterschiedliche Konfiguration der Koppelelemente 70, Spulenwicklungen mit unterschiedlichen Sensitivitätsbereichen bereitzustellen, mit denen es möglich ist, auf vorteilhafte Weise mit der gleichen Lokalspulenmatrix 50 optimale Untersuchungen so unterschiedlicher Bereiche des Patienten wie Abdomen oder Handgelenk vorzunehmen.

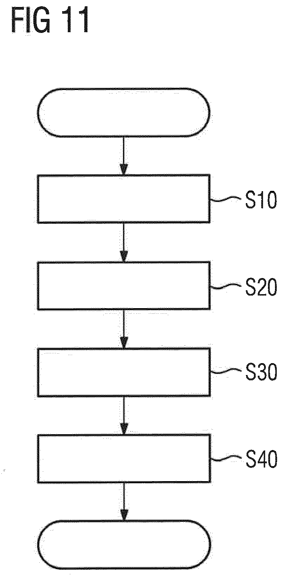

In Fig. 11 ist ein beispielhaftes Verfahren zum Betrieb eines Magnetresonanztomographen 1 mit einer erfindungsgemäßen Lokalspulenmatrix 50 dargestellt.

In einem Schritt S10 wird ein Scanparameter durch den Magnetresonanztomographen 1 ermittelt. Der Scanparameter ist eine Einstellung des Magnetresonanztomographen 1, die eine Veränderung des erfassten Bildes bewirkt.

Der Scanparameter kann beispielsweise eine Information zur Anordnung der Lokalspule wie Position, Abstand und/oder Ausrichtung der Lokalspulenmatrix relativ zu dem Magnetresonanztomographen 1 und/oder dem Patienten 100 sein. Diese Information kann beispielsweise durch eine Kamera und eine Bildauswertung durch den Magnetresonanztomographen 1 ermittelt werden. Denkbar ist es dabei, dass die Lokalspule 50 Markierungen aufweist, die der Magnetresonanztomograph einfacher auswerten kann.

Möglich wäre auch ein Pre-Scan, aus dessen Bild oder Messwerten die Lage der Lokalspule 50 auf dem Patienten und wiederum dessen Lage zum Feldmagneten 11 durch den Magnetresonanztomographen ermittelt werden kann.

Schließlich ist es aber auch denkbar, dass eine Einstellung einer Bedienperson direkt oder indirekt nach einer Verarbeitung durch die Steuereinheit 20 in einem Speicher der Steuereinheit 20 gespeichert wird, auf die der Magnetresonanztomograph 1 dann als Scanparameter zugreift. Dies können beispielsweise Beschleunigungsfaktoren innerhalb einer Schicht, sowie bei Mehrschichtabtastung, Geometrie des zu untersuchenden Bereichs, Art der zu erzeugenden Abbildung (z.B. 2D oder 3D) oder Phasenkodier-Richtung sein. Denkbar sind auch Scanparameter, die bei der Bilderfassung durch die Geometrie oder Sensitivitätsbereiche der Spulenwicklungen der Lokalspulenmatrix 50 beeinflusst werden.

In einem Schritt S20 Ermittelt der Magnetresonanztomograph 1 einer Konfiguration der Lokalspulenmatrix in Abhängigkeit von dem Scanparameter, z.B. mit der Steuereinheit. Beispielsweise kann aus der relativen Position der Lokalspule 50 zu dem Patienten 100 und dem Ziel der Untersuchung, z.B. Leber, ermittelt werden, welche Spulenwicklungen mit ihrem Sensitivitätsbereich das Organ erreichen, d.h. aufgrund der Tiefe wird nicht nur eine oder mehrere Spulen nach ihrer Lage ausgewählt, sondern auch noch die geeignete Spulengröße ausgewählt oder eine entsprechende Konfiguration der Koppelemente 70 ausgewählt, die eine Spule in der Position mit geeigneter Größe bereitstellt.

Sind dabei kleinere Spulen aufgrund der geringen Tiefe des Untersuchungsbereichs ausreichend, kann entsprechend je nach gewünschter Bildqualität und Beschleunigungsfaktor eine große oder eine kleine Spule gewählt werden. Wird der Bereich beispielsweise durch mehrere, in ihren Sensitivitätsbereichen nicht überlappenden Spulenwicklungen abgedeckt, kann die Konfiguration auch eine Parallelabtastung über diese Spulenwicklungen vorsehen.

In einem Schritt S30 wird die Lokalspulenmatrix 50 gemäß der ermittelten Konfiguration eingestellt. Das Einstellen kann beispielsweise eine Aktivierung oder Deaktivierung eines Verstimmungselementes zum Verstimmen der Spulenwicklung betreffen oder in einer anderen Ausführungsform kann es die Einstellung eines Koppelelements 70. Denkbar ist auch die Einstellung der Schaltmatrix 60, die dann z.B. nur die zur Bilderfassung gerade erforderlichen Spulenwicklungen der Lokalspule 50 mit den Empfängern des Magnetresonanztomographen verbindet.

Das Einstellen der Konfiguration erfolgt ausgehend von dem Magnetresonanztomographen 1, dessen Steuereinheit 20 die Bilderfassung steuert, über eine Signalverbindung zu der Lokalspulenmatrix 50. Je nach Art der Einstellung und der verwendeten Architektur kann die Signalverbindung direkt zu den einzelnen Koppelelementen 70, der Schaltmatrix 60 oder den Verstimmungselementen führen oder mit einer eigenen Lokalspulensteuerung umgesetzt und dann die einzustellenden Elemente verteilt werden, wodurch Signalleitungen zwischen Lokalspulenmatrix 50 und Magnetresonanztomograph 1 eingespart werden können.

Der Schritt S30 des Einstellens kann auch in Teilschritten erfolgen, wenn die Konfiguration auch einen zeitlichen Ablauf aufweist. Dies ist denkbar, wenn beispielsweise bei einer Parallelabtastung zwischen verschiedenen Spulenwicklungen oder ganzen Schichten gewechselt werden muss.

In einem Schritt S40 wird dann von dem Magnetresonanztomographen 1 eine Bilderfassung mit der Lokalspulenmatrix 50 ausgeführt. Der Schritt S40 kann dabei gleichzeitig mit Teilschritten zu Schritt S30, dem Einstellen der Konfiguration, ausgeführt werden, wenn während der Bilderfassung Änderungen innerhalb der Konfiguration vorgesehen sind.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Lokalspulenmatrix, wobei die Lokalspulenmatrix 50
eine Mehrzahl an Spulenwicklungen aufweist und ausgelegt ist, bei einer Magnetresonanztomographie einen vorbestimmten Bereich eines in Nachbarschaft zu der Lokalspulenmatrix 50 angeordneten Patienten mit auswählbaren unterschiedlich großen Sensitivitätsbereichen erfassen zu können.

2. Lokalspulenmatrix nach Anspruch 1, wobei eine erste Spulenwicklung aus der Mehrzahl der Spulenwicklungen einen ersten Sensitivitätsbereich aufweist und eine zweite Spulenwicklung aus der Menge der zweiten Spulenwicklungen einen zweiten Sensitivitätsbereich aufweist, wobei der erste Sensitivitätsbereich eine Teilmenge des zweiten Sensitivitätsbereiches ist.

3. Lokalspulenmatrix nach Anspruch 2, wobei die Lokalspulenmatrix (50) eine Mehrzahl an ersten Spulenwicklungen aufweist, wobei eine Vereinigungsmenge der Projektionen der ersten Sensitivitätsbereiche auf die zweite Spulenwicklung den zweiten Sensitivitätsbereich umfasst.

4. Lokalspulenmatrix nach Anspruch 2 oder 3, wobei die Lokalspulenmatrix (50) eine Mehrzahl an zweiten Spulenwicklungen aufweist, die jeweils erste Spulenwicklungen aufweisen, deren Sensitivitätsbereich Teilmenge des Sensitivitätsbereichs der jeweiligen zweiten Spulenwicklung ist.

5. Lokalspulenmatrix nach Anspruch 4, wobei die zweiten Sensitivitätsbereiche der Mehrzahl der zweiten Spulenwicklungen im Wesentlichen disjunkt sind.

6. Lokalspulenmatrix nach Anspruch 1, wobei die Lokalspulenmatrix (50) ein Koppelelement (70) oder mehrere Koppelelemente (70), mehrere Spulensegmente (55) und eine Steuerung in Signalverbindung mit dem Koppelelement (70) oder den Koppelelementen (70) aufweist, wobei das Koppelelement (70) oder die Koppelelemente (70) jeweils mit mindestens zwei Spulensegmenten (55) in Signalverbindung stehen,
wobei die Steuerung ausgelegt ist, die Spulensegmente (55) durch Aktivieren eines ersten Schaltzustandes des Koppelelements (70) bzw. der Koppelelemente (70) zu einer ersten Spulenwicklung und Aktivieren eines zweiten Schaltzustandes des Koppelelements (70) bzw. der Koppelelemente (70) zu einer zweiten Spulenwicklung zu verschalten, wobei die erste Spulenwicklung eine kleinere umschlossene Fläche aufweist als die zweite Spulenwicklung.

7. Lokalspulenmatrix nach Anspruch 6, wobei die Spulensegmente (55) selbstresonant bei der Larmorfrequenz ausgebildet sind.

8. Lokalspulenmatrix nach Anspruch 6 oder 7, wobei die Lokalspulenmatrix (50) eine Vielzahl an Spulensegmenten (55) aufweist, wobei die Spulensegmente (55) ein zweidimensionales Netz aus Polygonen mit Knotenpunkten aufspannen.

9. Lokalspulenmatrix nach Anspruch 8, wobei eine Mehrzahl an Knotenpunkten mit einem Koppelelement (70) besetzt ist.

10. Lokalspulenmatrix nach einem der vorhergehenden Ansprüche, wobei die Lokalspulenmatrix (50) eine Schaltmatrix (60) mit ersten Signalanschlüssen (61) und zweiten Signalanschlüssen (62) aufweist, wobei die ersten der Signalanschlüsse (61) mit der Mehrzahl der Spulenwicklungen in Signalverbindung steht, wobei die Schaltmatrix (60) ausgelegt ist, jeden der ersten Signalanschlüsse (61) mit mindestens einem der zweiten Signalanschlüsse (62) in Signalverbindung zu schalten.

11. Lokalspulenmatrix nach Anspruch 8 mit einer Schaltmatrix (60) nach Anspruch 10, wobei die ersten Signalanschlüssen (61) derart mit den Spulensegmenten (55) in Signalverbindung stehen, dass die durch die Koppelelemente (70) geschalteten Spulenwicklungen mit den zweiten Signalanschlüssen (62) durch die Steuerung wahlfrei verbindbar sind.

12. Verfahren zum Betrieb eines Magnetresonanztomographen (1) mit einer Lokalspulenmatrix (50) nach einem der vorhergehenden Ansprüche, wobei das Verfahren die Schritte aufweist:
(S10) Ermitteln eines Scanparameters durch den Magnetresonanztomographen (1);
(S20) Ermitteln einer Konfiguration der Lokalspulenmatrix (50) in Abhängigkeit von dem Scanparameter durch den Magnetresonanztomographen (1);
(S30) Einstellen der Lokalspulenmatrix (50) gemäß der ermittelten Konfiguration;
(S40) Ausführen einer Bilderfassung durch den Magnetresonanztomographen (1) mit Hilfe der Lokalspulenmatrix (50).

13. Verfahren nach Anspruch 12, wobei der Scanparameter einer aus Anordnung der Lokalspulenmatrix (50), Beschleunigungsfaktor, Geometrie des Untersuchungsbereichs, Art der zu erzeugenden Abbildung und Phasenkodier-Richtung ist.

14. Verfahren nach Anspruch 12 oder 13, wobei das Ermitteln des Untersuchungsparameters einen Schritt des Aufnehmens und Auswertens eines Pre-Scans aufweist.

15. Verfahren nach Anspruch 12 oder 13, wobei das Ermitteln des Scanparameters ein Erfassen einer Position der Lokalspulenmatrix relativ zu dem Patienten durch den Magnetresonanztomographen (1) umfasst.
